(19) Europäisches Patentamt
European Patent Office
Office européen des brevets

(11) **EP 2 887 405 A1**

(12) **EUROPÄISCHE PATENTANMELDUNG**

(43) Veröffentlichungstag:
**24.06.2015 Patentblatt 2015/26**

(51) Int Cl.:
***H01L 31/0749*** *(2012.01)*

(21) Anmeldenummer: **13199305.7**

(22) Anmeldetag: **23.12.2013**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Saint-Gobain Glass France**
**92400 Courbevoie (FR)**

(72) Erfinder:
• **Verma, Rajneesh**
**81243 München (DE)**
• **Pohlner, Stephan**
**81541 München (DE)**

• **Dietmüller, Roland**
**80636 München (DE)**
• **Dalibor, Thomas**
**82211 Herrsching am Ammersee (DE)**
• **Happ, Thomas**
**81825 München (DE)**
• **Palm, Jörg**
**80797 München (DE)**

(74) Vertreter: **Gebauer, Dieter Edmund**
**Splanemann**
**Patentanwälte Partnerschaft**
**Rumfordstraße 7**
**80469 München (DE)**

(54) **Schichtsystem für Dünnschichtsolarzellen**

(57) Die vorliegende Erfindung betrifft ein Schichtsystem für Dünnschichtsolarzellen, mit einer Absorberschicht, die einen Chalkogenid-Verbindungshalbleiter enthält, und einer Pufferschicht, die auf der Absorberschicht angeordnet ist, wobei die Pufferschicht ein Halbleitermaterial, enthaltend Indium (In), Schwefel (S) und wenigstens einem Element, gewählt aus der Gruppe, bestehend aus Kalium (K) und Cäsium (Cs), aufweist. Des Weiteren betrifft sie eine Dünnschichtsolarzelle mit einem solchen Schichtsystem sowie ein Verfahren zur Herstellung eines Schichtsystems.

FIG. 1

**Beschreibung**

Die vorliegende Erfindung liegt auf dem technischen Gebiet der Fertigung von Solarzellen und Solarmodulen und betrifft ein Schichtsystem für Dünnschichtsolarzellen sowie ein Verfahren zur Herstellung eines solchen Schichtsystems.

Dünnschichtsysteme für Solarzellen und Solarmodule sind hinreichend bekannt und in verschiedenen Ausführungen, je nach Substrat und aufgebrachten Materialien, auf dem Markt vorhanden. Die Materialien werden so gewählt, dass das einfallende Sonnenspektrum maximal ausgenutzt wird. Aufgrund der physikalischen Eigenschaften und der technologischen Handhabbarkeit sind Dünnschichtsysteme mit Halbleitern aus amorphem, mikromorphem oder polykristallinem Silizium, Cadmium-Tellurid (CdTe), Gallium-Arsenid (GaAs), Kupfer-Indium(Gallium)-Selenid(Sulfid) ($Cu(In,Ga)(S,Se)_2$), Kupfer-Zink-Zinn-Sulfo-Selenid (CZTS) aus der Gruppe der Kesterite, sowie organischen Halbleitern besonders für Solarzellen geeignet. Der pentenäre Halbleiter $Cu(In,Ga)(S,Se)_2$ gehört zur Gruppe der Chalkopyrit-Halbleiter, die häufig als CIS (Kupferindiumdiselenid oder -sulfid) oder CIGS (Kupferindiumgalliumdiselenid, Kupferindiumgalliumdisulfid oder Kupferindiumgalliumdisulfoselenid) bezeichnet werden. S kann in der Abkürzung CIS bzw. CIGS für Selen, Schwefel oder eine Mischung beider Chalkogene stehen.

Aktuelle Dünnschichtsolarzellen und Solarmodule auf Basis von $Cu(In,Ga)(S,Se)_2$ benötigen eine Pufferschicht zwischen einer p-leitenden $Cu(In,Ga)(S,Se)_2$-Absorber-schicht und einer n-leitenden Frontelektrode. Die Frontelektrode enthält üblicherweise Zinkoxid (ZnO). Nach derzeitiger Erkenntnis ermöglicht diese Pufferschicht eine elektronische Anpassung zwischen Absorbermaterial und Frontelektrode. Sie bietet außerdem einen Schutz vor Sputterschäden im nachfolgenden Prozessschritt der Abscheidung der Frontelektrode durch DC-Magnetron-Sputtern. Zusätzlich verhindert sie den Stromabfluss von elektronisch gutleitenden Bereichen in schlecht-leitende Bereiche durch Aufbau einer hochohmigen Zwischenschicht zwischen p- und n-Halbleiter.

Bisher wurde am häufigsten Kadmiumsulfid (CdS) als Pufferschicht verwendet. Um gute Wirkungsgrade der Zelle erzeugen zu können, wird Kadmiumsulfid in einem chemischen Badprozess (CBD-Prozess) nasschemisch abgeschieden. Nachteilig ist, dass der nasschemische Prozess nicht gut in den von Vakuumprozessen geprägten Prozessablauf der gegenwärtigen Produktion von Dünnschichtsolarzellen passt. Ein weiterer Nachteil der CdS-Pufferschicht besteht darin, dass sie das toxische Schwermetall Kadmium enthält. Dadurch entstehen höhere Produktionskosten, da erhöhte Sicherheitsvorkehrungen im Produktionsprozess getroffen werden müssen und das Abwasser aufwändig entsorgt werden muss. Ein weiterer Nachteil von CdS-Pufferschichten liegt darin begründet, dass Kadmiumsulfid ein Halbleiter mit einer elektronischen Bandlücke von etwa 2,4 eV ist. Daher wird in einer $Cu(In,Ga)(S,Se)_2$/CdS/ZnO-Solarzelle schon bei CdS-Schichtdicken von einigen 10 nm das einfallende Licht in erheblichem Umfang absorbiert. Das in der Pufferschicht absorbierte Licht geht für die elektrische Ausbeute verloren, da die erzeugten Ladungsträger in dieser Schicht gleich wieder rekombinieren und es in diesem Bereich des Heteroübergangs und im Puffermaterial viele als Rekombinationszentren wirkende Kristalldefekte gibt. Als Folge wird der Wirkungsgrad der Solarzelle kleiner, was für eine Dünnschichtsolarzelle nachteilig ist.

Es wurden daher verschiedene Alternativen zu Kadmiumsulfid für unterschiedliche Absorber aus der Familie der $Cu(In,Ga)(S,Se)2$-Halbleiter getestet, beispielsweise gesputtertes ZnMgO, durch CBD abgeschiedenes Zn(S,OH), durch CBD abgeschiedenes In(O,OH) und Indiumsulfid, abgeschieden durch Atomic Layer Deposition (ALD), Ion Layer Gas Deposition (ILGAR), Sprühpyrolyse oder Physical Vapor Deposition (PVD)-Verfahren, wie thermisches Verdampfen oder Sputtern.

Allerdings eignen sich diese Materialien nicht für eine kommerzielle Nutzung, da mit ihnen nicht die gleichen Wirkungsgrade erreicht werden können wie mit einer CdS-Pufferschicht. Der Wirkungsgrad einer Solarzelle beschreibt das Verhältnis von eingestrahlter Leistung zur erzeugten elektrischen Leistung und beträgt für CdS-Pufferschichten für Laborzellen auf kleinen Flächen bis etwa 20 % sowie für großflächige Module zwischen 10% und 15%. Weiterhin zeigen alternative Pufferschichten zu große Instabilitäten, Hystereseeffekte oder Degradationen im Wirkungsgrad, wenn sie Licht, Wärme und/oder Feuchte ausgesetzt sind.

Ein Schichtsystem mit einer Pufferschicht auf Basis von Indiumsulfid ist beispielsweise aus WO2009/141132 A2 bekannt. In der bisherigen Entwicklung dieser Schichtsysteme hat sich jedoch gezeigt, dass der Wirkungsgrad von Solarzellen mit Indiumsulfid-Pufferschicht kleiner ist als der von Solarzellen mit CdS-Pufferschichten.

Aufgabe der vorliegenden Erfindung ist es daher, ein Schichtsystem auf Basis eines Chalkogenidverbindungshalbleiters mit einer Pufferschicht bereitzustellen, das einen hohen Wirkungsgrad und eine hohe Stabilität einer hieraus gefertigten Solarzelle ermöglicht, wobei die Herstellung kostengünstig und umweltverträglich sein soll.

Diese Aufgabe wird erfindungsgemäß durch ein Schichtsystem gemäß Patentanspruch 1 gelöst. Vorteilhafte Ausführungsformen der Erfindung sind in den Unteransprüchen angegeben.

Das erfindungsgemäße Schichtsystem umfasst eine Absorberschicht, die einen Chalkogenidverbindungshalbleiter enthält. In einer vorteilhaften Ausführungsform der Erfindung handelt es sich bei dem Chalkogenidverbindungshalbleiter um einen Halbleiter vom Chalkopyrit-Typ der Formel $Cu(In,Ga,Al)(S,Se)_2$, insbe-

sondere $CuInSe_2$, $CuInS_2$, $Cu(In,Ga)Se_2$ oder $Cu(In,Ga)(S,Se)_2$. In einer weiteren vorteilhaften Ausführungsform der Erfindung handelt es sich bei dem Chalkogenidverbindungshalbleiter um einen Halbleiter vom Kesterit/Stannit-Typ der Formel $Cu_2ZnSn(S,Se)_4$, insbesondere $Cu_2ZnSnS_4$. In den genannten Formeln können die in Klammern stehenden Elemente allein oder in Kombination vorhanden sein.

Das Schichtsystem umfasst weiterhin eine Pufferschicht, die auf der Absorberschicht angeordnet ist. Die Pufferschicht enthält ein Halbleitermaterial, welches Indium (In), Schwefel (S) und wenigstens einem Element, gewählt aus der Gruppe, bestehend aus Kalium (K) und Cäsium (Cs), aufweist. Somit können die Elemente Kalium und Cäsium jeweils allein oder in Kombination in der Pufferschicht enthalten sein. Das in der Pufferschicht enthaltene Halbleitermaterial kann durch die Formel $A_xIn_yS_z$ mit A = K und/oder Cs beschrieben werden, wobei die Parameter x, y, z die Anteile des jeweiligen Elements in dem Halbleitermaterial, bezogen auf die in der Formel angegebenen Bestandteile des Halbleitermaterials, beschreiben. Somit beschreiben die Parameter x, y, z das atomare Verhältnis des jeweils zugehörigen Stoffs, bezogen auf den summarischen Gehalt an den in der Formel angegeben Stoffen. Beispielsweise ist durch die Formel $KIn_2S_3$ angegeben, dass der Anteil von Kalium im Halbleitermaterial, bezogen auf die durch die Formel angegebenen Bestandteile des Halbleitermaterials, 1/6 beträgt, was einem relativen Gehalt von ca. 17 Atom-% entspricht. Indium liegt in einem Anteil von 2/6 vor, entsprechend einem Gehalt von ca. 33 Atom-%. Schwefel liegt in einem Anteil von 3/6 vor, entsprechend einem Gehalt von 50 Atom-%. Es versteht sich, dass im Halbleitermaterial der Pufferschicht weitere, hier nicht genannte Elemente, insbesondere Verunreinigungen, enthalten sein können.

Da die Elemente der Pufferschicht jeweils in verschiedenen Oxidationsstufen vorliegen können, werden im Folgenden alle Oxidationsstufen einheitlich mit dem Namen des Elements bezeichnet, sofern dies nicht explizit anders gekennzeichnet wird. Beispielsweise ist unter "Kalium" elementares Kalium, Kaliumionen sowie Kalium in einer Verbindung zu verstehen.

Wie Untersuchungen der Erfinder überraschenderweise ergaben, kann durch Kalium oder Cäsium in einer Indiumsulfid-haltigen Pufferschicht eine deutliche Erhöhung des Wirkungsgrads von Solarzellen erreicht werden. Ohne hierauf eingeschränkt zu sein, wird als Ursache für die Erhöhung des Wirkungsgrads derzeit angenommen, dass sich durch Kalium oder Cäsium unterschiedliche Kristallstrukturen ausbilden, was beim Schichtwachstum zu einer feinkristallineren Schicht führt, verglichen mit einer kalium- bzw. cäsiumfreien Indiumsulfid-Pufferschicht. Zudem wird angenommen, dass der relativ große Atomradius von Kalium oder Cäsium die Ausbildung der Indiumsulfid-Kristallstruktur stört und somit auch die Kristallinität verringert. Dies hat zur Folge, dass die Eindiffusion von Elementen, beispielsweise Kupfer, aus der Absorberschicht in die Pufferschicht reduziert ist, was den Wirkungsgrad der Solarzelle steigert.

Zudem kann durch das Einbringen von Kalium oder Cäsium in eine Indiumsulfid-haltige Pufferschicht die Bandlücke der Pufferschicht aufgeweitet werden. Dies ist sowohl für eine Bandanpassung an der Absorber-Puffer-Grenzfläche als auch für eine Verminderung der Lichtabsorption in der Pufferschicht von Vorteil.

Wie die Erfinder weiterhin beobachten konnten, haben Kalium oder Cäsium in einer Indiumsulfid-haltigen Pufferschicht eine relativ geringe Diffusionsneigung, mit der Folge, dass nur ein geringer Anteil aus der Pufferschicht in die Absorberschicht eindiffundiert. Somit können in vorteilhafter Weise Kurzschluss (Shunt-)Pfade vermieden werden, die ansonsten über die so genannte P1-Strukturierung entstehen können und den Wirkungsgrad von Solarmodulen begrenzen und zu einem schlechteren Schwachlichtverhalten führen. Dies eröffnet die Möglichkeit, den Anteil von Kalium oder Cäsium in der Pufferschicht zu steigern und die Bandlücke noch stärker aufzuweiten, um eine Verbesserung der Transmission in Solarmodulen und somit eine Verbesserung des Wirkungsgrads zu erreichen.

Bei einer vorteilhaften Ausführungsform des erfindungsgemäßen Schichtsystems, umfasst die Pufferschicht ein Halbleitermaterial der Formel $A_xIn_yS_z$ mit A = K und/oder Cs der folgenden Zusammensetzung: $0,05 \leq x/(x+y+z) \leq 0,25$ und $0,30 \leq y/(y+z) \leq 0,45$. In diesen Bereichen kann in vorteilhafter Weise eine erhebliche Wirkungsgradverbesserung von Solarzellen erreicht werden. Besonders vorteilhaft hat das Halbleitermaterial folgende Zusammensetzung: $0,05 \leq x/(x+y+z) \leq 0,20$ und $0,30 \leq y/(y+z) \leq 0,45$. Für diese Werte konnten besonders hohe Wirkungsgrade gemessen werden.

Bei einer weiteren vorteilhaften Ausführungsform des erfindungsgemäßen Schichtsystems, umfasst die Pufferschicht ein Kalium-Indiumsulfid-Halbleitermaterial der Formel $K_xIn_yS_z$ mit $0,05 \leq x/(x+y+z) \leq 0,15$ und $0,35 \leq y/(y+z) \leq 0,45$. Für diese Werte konnten besonders hohe Wirkungsgrade gemessen werden.

Bei einer weiteren vorteilhaften Ausführungsform des erfindungsgemäßen Schichtsystems, umfasst die Pufferschicht ein Cäsium-Indiumsulfid-Halbleitermaterial der Formel $Cs_xIn_yS_z$ mit $0,05 \leq x/(x+y+z) \leq 0,12$ und $0,35 \leq y/(y+z) \leq 0,45$. Für diese Werte konnten besonders hohe Wirkungsgrade gemessen werden.

Bei einer weiteren vorteilhaften Ausführungsform des erfindungsgemäßen Schichtsystems weist die Pufferschicht wenigstens ein Halogen, insbesondere gewählt aus der Gruppe, bestehend aus Fluor (F), Chlor (Cl), Brom (Br) und Iod (I), auf. In vorteilhafter Weise entspricht ein Halogengehalt der Pufferschicht einem Alkaligehalt der Pufferschicht, was sich beispielsweise aus der Stöchiometrie beim Einbringen von Kalium bzw. Cäsium als Halogenverbindung ergeben kann. Wie Versuche der Anmelderin gezeigt haben, kann durch das Halogen die optische Bandlücke der Pufferschicht noch stärker aufgeweitet werden, so dass der Wirkungsgrad einer Solarzelle noch weiter verbessert wird.

Bei einer weiteren vorteilhaften Ausführungsform der Erfindung umfasst das Schichtsystem eine wie oben beschrieben ausgebildete, $A_xIn_yS_z$ enthaltende Pufferschicht, welche auch als "erste Pufferschicht" bezeichnet wird, und eine zweite Pufferschicht, wobei die zweite Pufferschicht auf der ersten Pufferschicht angeordnet ist. Die zweite Pufferschicht enthält vorzugsweise undotiertes Zinkoxid (Zno) und/oder undotiertes Zink-Magnesiumoxid (ZnMgO). Mit diesem Aufbau können Solarzellen mit besonders hohem Wirkungsgrad hergestellt werden.

Bei einer weiteren vorteilhaften Ausführungsform des erfindungsgemäßen Schichtsystems, enthält die (erste) Pufferschicht Zink (Zn), wobei der Zinkgehalt maximal 15 Atom-%, bezogen auf die Elemente der Pufferschicht, beträgt. Vorzugsweise steigt der Zinkgehalt der ersten Pufferschicht zur zweiten Pufferschicht hin an.

Bei einer weiteren vorteilhaften Ausführungsform des erfindungsgemäßen Schichtsystems, weist die Pufferschicht eine Schichtdicke im Bereich von 5 nm bis 150 nm, insbesondere im Bereich von 15 nm bis 60 nm, auf.

Bei einer weiteren vorteilhaften Ausführungsform des erfindungsgemäßen Schichtsystems, ist die Pufferschicht so ausgebildet, dass eine Bandlücke der Pufferschicht im Bereich von 2 Elektronenvolt (eV) bis 2,8 Elektronenvolt (eV) vorliegt. Hierdurch können Solarzellen mit einem besonders hohen Wirkungsgrad hergestellt werden.

Bei einer weiteren vorteilhaften Ausführungsform enthält die erfindungsgemäße Pufferschicht einen Stoffmengenanteil an Kupfer von ≤ 10 Atom-%. Die Eindiffusion von größeren Mengen an Kupfer aus der Absorberschicht ist unvorteilhaft, da die Bandlücke der Pufferschicht durch Kupfer reduziert wird. Dies führt zu einer erhöhten Absorption des Lichtes in der Pufferschicht und damit zu einer Reduzierung des Wirkungsgrads. Wie Versuche der Erfinder gezeigt haben, führt die Verwendung von Kalium und/oder Cäsium in der Pufferschicht zu einer vorteilhaften Hemmung der Eindiffusion von Kupfer aus der Absorberschicht in die Pufferschicht. Durch einen Stoffmengenanteil von Kupfer in der Pufferschicht ≤ 10 Atom-% kann ein hoher Wirkungsgrad der Solarzelle sichergestellt werden.

In einer vorteilhaften Ausführungsform der erfindungsgemäßen Schichtstruktur weist die Pufferschicht keinen wesentlichen Anteil an weiteren Elementen als Kalium und/oder Cäsium, Indium und Sulfid auf (sowie gegebenenfalls einem Halogen, beispielsweise Chlor, falls Kalium bzw. Cäsium in einer Halogenverbindung abgeschieden wurden). Das bedeutet, dass die Pufferschicht nicht mit weiteren Elementen wie beispielsweise Kohlenstoff versehen ist und höchstens fertigungstechnisch nicht vermeidbare Stoffmengenanteile an weiteren Elementen von ≤ 1 Atom-% enthält. Dadurch lässt sich ein hoher Wirkungsgrad der Solarzelle sicherstellen.

Im erfindungsgemäßen Schichtsystem kann der Anteil von Kalium und/oder Cäsium in der Pufferschicht ein konstantes Tiefenprofil haben. Tiefenprofil im Sinne der vorliegenden Erfindung beschreibt die Richtung orthogonal zu den Schichten der Schichtstruktur, das bedeutet die Richtung parallel zur Dicke der einzelnen Schichten der Schichtstruktur. Alternativ kann der Anteil von Kalium und/oder Cäsium in der Pufferschicht ein nichtkonstantes Tiefenprofil aufweisen. Beispielsweise weist der Anteil von Kalium und/oder Cäsium in der Pufferschicht einen Gradienten auf, der von der der Absorberschicht näheren Oberfläche zu der der Absorberschicht ferneren Oberfläche der Pufferschicht hin abfällt. Gleichermaßen ist es möglich, dass der Anteil von Kalium und/oder Cäsium in der Pufferschicht einen Gradienten aufweist, der von der der Absorberschicht näheren Oberfläche zu der der Absorberschicht ferneren Oberfläche der Pufferschicht hin zunimmt. Ebenso ist möglich, dass der Anteil von Kalium und/oder Cäsium in der Pufferschicht einen Gradienten aufweist, der von der der Absorberschicht näheren Oberfläche zu der der Absorberschicht ferneren Oberfläche der Pufferschicht hin zunächst abfällt und dann wieder ansteigt, also ein Minimum zwischen den beiden Oberflächen aufweist. Des Weiteren ist möglich, dass der Anteil von Kalium und/oder Cäsium in der Pufferschicht einen Gradienten aufweist, der von der der Absorberschicht näheren Oberfläche zu der der Absorberschicht ferneren Oberfläche der Pufferschicht hin zunächst ansteigt und dann wieder abfällt, also ein Maximum zwischen den beiden Oberflächen aufweist. Die Stoffmengenanteile der einzelnen Elemente in der gesamten Pufferschicht bleiben dabei im Rahmen der in der Erfindung beanspruchten Bereiche. Ein nicht-kontantes Tiefenprofil kann beispielsweise durch eine variable Aufdampfrate hergestellt werden.

Ferner erstreckt sich die Erfindung auf eine Dünnschichtsolarzelle, die ein Substrat, eine Rückelektrode, die auf dem Substrat angeordnet ist, ein wie oben beschrieben ausgebildetes Schichtsystem, das auf der Rückelektrode angeordnet ist, und eine Frontelektrode, die auf dem Schichtsystem angeordnet ist, umfasst. Das Substrat ist beispielsweise ein Metall-, Glas-, Kunststoffoder Keramiksubstrat, wobei Glas bevorzugt wird. Es können aber auch andere transparente Trägermaterialien, insbesondere Kunststoffe verwendet werden. Die Rückelektrode umfasst vorteilhaft Molybdän (Mo) oder andere Metalle. In einer vorteilhaften Ausführungsform der Rückelektrode weist diese eine Molybdänteilschicht auf, die an die Absorberschicht angrenzt, und eine Siliziumnitridteilschicht (SiN), die an die Molybdän-Teilschicht angrenzt. Derartige Rückelektrodensysteme sind beispielsweise aus EP 1356528 A1 bekannt. Die Frontelektrode enthält bevorzugt ein transparentes leitendes Oxid (TCO), besonders bevorzugt Aluminium-, Gallium- oder Bor-dotiertes Zinkoxid und/oder Indium-Zinnoxid (ITO).

In einer vorteilhaften Ausführungsform der erfindungsgemäßen Dünnschichtsolarzelle ist zwischen der Pufferschicht und der Frontelektrode eine zweite Pufferschicht angeordnet. Die zweite Pufferschicht enthält vorzugsweise undotiertes Zinkoxid und/oder undotiertes Zink-Magnesiumoxid.

Darüber hinaus erstreckt sich die Erfindung auf ein Verfahren zur Herstellung eines - wie oben beschrieben ausgebildeten - erfindungsgemäßen Schichtsystems.

Das Verfahren umfasst einen Schritt, bei dem eine Absorberschicht, die einen Chalkogenidverbindungshalbleiter enthält, bereitgestellt wird. Zweckmäßig wird die Absorberschicht in einem RTP-Prozess (RTP = Rapid Thermal Processing) auf ein Substrat mit Rückelektrode aufgebracht. Für Cu(In,Ga)(S,Se)$_2$-Absorberschichten wird dabei zunächst eine Vorläuferschicht auf die Rückelektrode abgeschieden. Die Vorläuferschicht enthält die Elemente Kupfer, Indium und/oder Gallium, die durch Sputtern aufgebracht werden. Des Weiteren enthält die Vorläuferschicht elementares Selen und/oder elementaren Schwefel, welche durch thermisches Verdampfen aufgebracht werden. Bei diesen Prozessen liegt die Substrattemperatur unterhalb von 100°C, so dass die Elemente im Wesentlichen unreagiert erhalten bleiben. Anschließend wird diese Vorläuferschicht im schnellen Temperverfahren in schwefel- und/oder selenhaltiger Atmosphäre zu einem Cu(In,Ga)(S,Se)$_2$-Chalcopyrithalbleiter reagiert.

Weiterhin umfasst das Verfahren einen Schritt, bei dem eine Pufferschicht auf der Absorberschicht angeordnet wird, wobei die Pufferschicht A$_x$In$_y$S$_z$ enthält, wobei A wenigstens ein Element, gewählt aus der Gruppe, bestehend aus K und Cs, ist. Die Pufferschicht wird entsprechend der Pufferschicht des oben beschriebenen, erfindungsgemäßen Schichtsystems ausgebildet.

Zur Herstellung der Pufferschicht sind prinzipiell alle chemisch-physikalischen Abscheideverfahren geeignet, bei denen das Verhältnis des Anteils von Kalium bzw. Cäsium zum Indiumsulfid-Anteil gesteuert werden kann. Vorteilhaft wird die erfindungsgemäße Pufferschicht durch Atomic Layer Deposition (ALD), Ion Layer Gas Deposition (ILGAR), Sprühpyrolyse, Chemical Vapor Deposition (CVD) oder Physical Vapor Deposition (PVD) auf die Absorberschicht aufgebracht. Die erfindungsgemäße Pufferschicht wird bevorzugt durch Sputtern (Kathodenzerstäubung), thermisches Verdampfen oder Elektronenstrahlverdampfen abgeschieden, besonders bevorzugt aus separaten Quellen für Kalium (vorzugsweise in Form einer Kalium-Halogen-Verbindung) und/oder Cäsium (vorzugsweise in Form einer Cäsium-Halogen-Verbindung) und Indiumsulfid. Indiumsulfid kann entweder aus getrennten Quellen für Indium und Schwefel verdampft werden oder aus einer Quelle mit einem In$_2$S$_3$-Verbindungshalbleitermaterial. Auch andere Indiumsulfide (In$_6$S$_7$ oder InS) sind in Kombination mit einer Schwefelquelle möglich.

Besonders vorteilhaft wird die erfindungsgemäße Pufferschicht mit einem Vakuumverfahren abgeschieden. Das Vakuumverfahren hat den besonderen Vorteil, dass im Vakuum der Einbau von Sauerstoff oder Hydroxid verhindert wird. Hydroxid-Komponenten in der Pufferschicht sind vermutlich verantwortlich für Transienten des Wirkungsgrades bei Einwirkung von Wärme und Licht. Des Weiteren haben Vakuumverfahren den Vorteil, dass das Verfahren ohne Nasschemie auskommt und Standard-Vakuumbeschichtungsanlagen verwendet werden können.

In einer besonders vorteilhaften Ausführungsform des erfindungsgemäßen Verfahrens werden eine Kalium-Verbindung und/oder eine Cäsium-Verbindung aus einer ersten Quelle und Indiumsulfid (In$_2$S$_3$) aus einer separaten, zweiten Quelle verdampft.

Die Anordnung der Abscheidungsquellen ist beispielsweise derart gestaltet ist, dass sich die Dampfkeulen der Quellen zumindest teilweise, insbesondere vollständig, überlappen. Hierdurch kann eine sehr homogene Pufferschicht erzeugt werden, wodurch besonders hohe Wirkungsgrade erreicht werden. Dampfkeule im Sinne der Erfindung meint den Bereich vor dem Auslass der Quelle, welcher für die Abscheidung des verdampften Materials auf einem Substrat hinsichtlich Aufdampfrate und Homogenität technisch geeignet ist. Die Quelle ist beispielsweise eine Effusionszelle, ein Schiffchen oder Tiegel eines thermischen Verdampfers, einer Widerstandsheizung, eines Elektronenstrahlverdampfer oder eines Linearverdampfers.

Bei einer alternativen Anordnung überlappen sich die Dampfkeulen der Quellen nicht oder nur teilweise. Vorzugsweise wird die Kalium- und/oder Cäsiumverbindung zeitlich vor dem Indiumsulfid abgeschieden, wodurch in besonders vorteilhafter Weise eine elektrische Grenzflächenpassivierung der Absorberschicht erreicht werden kann. Hierdurch kann die Lebensdauer von Ladungsträgern erhöht werden, wodurch sich der Wirkungsgrad der Solarzelle verbessert.

In einer vorteilhaften Ausführungsform des erfindungsgemäßen Verfahrens wird die Absorberschicht in einem In-Line-Verfahren oder in einem Rotations-Verfahren an einer Dampfkeule einer Kalium-Verbindung und/oder einer Cäsium-Verbindung und einer Dampfkeule von Indiumsulfid bzw. Dampfkeulen von Indium und Schwefel vorbeigeführt. Die Dampfkeulen überlappen sich ganz oder teilweise.

Die verschiedenen Ausführungsformen der Erfindung können allein oder in beliebiger Kombination vorliegen, ohne den Rahmen der Erfindung zu verlassen.

Die Erfindung wird im Weiteren näher erläutert, wobei Bezug auf die beigefügten Zeichnungen genommen wird. Es zeigen:

Fig. 1    eine schematische Querschnittansicht einer Dünnschichtsolarzelle gemäß vorliegender Erfindung;

Fig. 2    eine Messung des Wirkungsgrads einer Dünnschichtsolarzelle mit dem Aufbau von Fig. 1 in Abhängigkeit des Kaliumanteils in der Pufferschicht;

Fig. 3     eine Messung des Wirkungsgrads einer Dünnschichtsolarzelle mit dem Aufbau von Fig. 1 in Abhängigkeit des Cäsiumanteils in der Pufferschicht;

Fig. 4     eine Messung der Bandlücke von $K_xIn_yS_z$ -Puf-ferschichten bzw. $Na_xIn_yS_z$ -Pufferschichten in Abhängigkeit des Alkalianteils;

Fig. 5     eine Messung der optischen Transmission von $Cs_xIn_yS_z$ -Pufferschichten in Abhängigkeit des Cäsiumanteils;

Fig. 6     eine Messung des Wirkungsgrads von Dünn-schichtsolarmodulen einer Dünnschichtsolar-zelle mit cäsiumhaltigen bzw. natriumhaltigen Indiumsulfid-Pufferschichten;

Fig. 7     eine Messung des Kurschlussstroms der Dünnschichtsolarmodule von Fig. 6;

Fig. 8     eine schematische Darstellung eines In-Line-Verfahrens zur Herstellung der Pufferschicht des erfindungsgemäßen Schichtsystems;

Fig. 9     eine schematische Darstellung eines Rotations-Verfahrens zur Herstellung der Puffer-schicht des erfindungsgemäßen Schichtsys-tems.

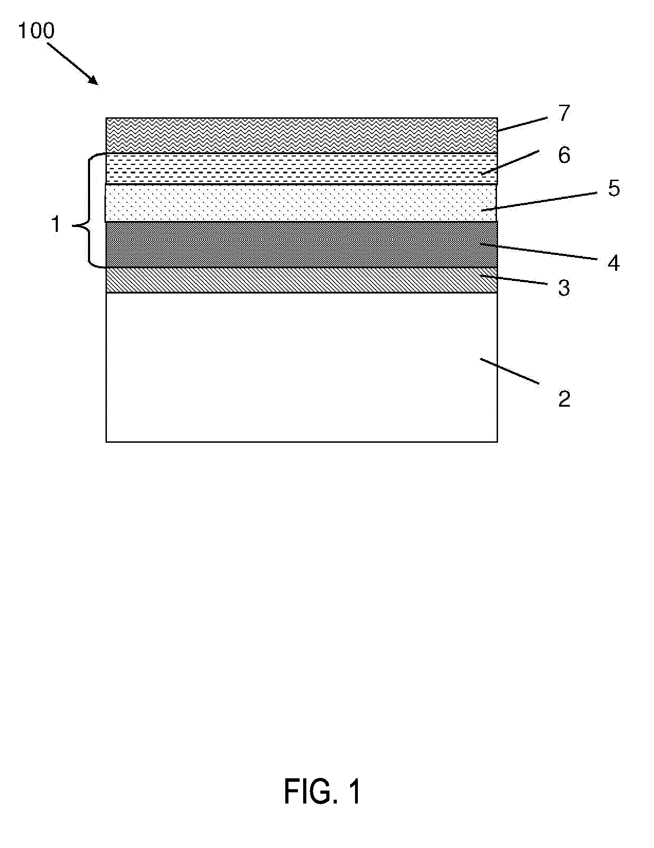

Figur 1 zeigt rein schematisch ein Ausführungs-beispiel einer erfindungsgemäßen Dünnschichtsolarzel-le 100 mit einem erfindungsgemäßen Schichtsystem 1 in einer Querschnittansicht. Die Dünnschichtsolarzelle 100 umfasst ein Substrat 2 und eine Rückelektrode 3. Auf der Rückelektrode 3 ist das erfindungsgemäße Schichtsystem 1 angeordnet. Das erfindungsgemäße Schichtsystem 1 umfasst eine Absorberschicht 4, eine erste Pufferschicht 5 sowie optional eine zweite Pufferschicht 6. Auf dem Schichtsystem 1 ist eine Frontelektrode 7 angeordnet.

Das Substrat 2 besteht hier beispielsweise aus anorganischem Glas, wobei gleichermaßen andere isolierende Materialien mit genügender Festigkeit, sowie inertem Verhalten gegenüber den bei der Herstellung der Dünnschichtsolarzelle 100 durchgeführten Prozessschritten eingesetzt werden können, beispielsweise Kunststoffe, insbesondere Polymere oder Metalle, insbesondere Metall-Legierungen. In Abhängigkeit der Schichtdicke und den spezifischen Materialeigenschaften kann das Substrat 2 als starre Platte oder biegsame Folie ausgestaltet sein. Im vorliegenden Ausführungsbeispiel beträgt die Schichtdicke des Substrats 2 beispielsweise 1 mm bis 5 mm.

Auf der lichteintrittsseitigen Oberfläche des Substrats 2 ist die Rückelektrode 3 angeordnet. Die Rückelektrode 3 besteht beispielsweise aus einem lichtundurchlässigen Metall. Sie kann beispielsweise durch Auf-dampfen oder magnetfeldunterstützte Kathodenzerstäu-bung auf dem Substrat 2 abgeschieden werden. Die Rückelektrode 3 besteht beispielsweise aus Molybdän (Mo), Aluminium (Al), Kupfer (Cu), Titan (Ti) oder aus einem Mehrschichtsystem mit einem solchen Metall, beispielsweise Molybdän (Mo). Die Schichtdicke der Rückelektrode 3 ist hier geringer als 1 $\mu$m, liegt vorzugsweise im Bereich von 300 nm bis 600 nm und beträgt beispielsweise 500 nm. Die Rückelektrode 3 dient als Rückssei-tenkontakt der Dünnschichtsolarzelle 100. Zwischen dem Substrat 2 und der Rückelektrode 3 kann eine Alkali-Barriere angeordnet sein, welche beispielsweise aus $Si_3N_4$, SiON oder SiCN besteht. Dies ist in Figur 1 nicht näher dargestellt.

Auf der Rückelektrode 3 ist das erfindungsgemäße Schichtsystem 1 angeordnet. Das Schichtsystem 1 enthält eine Absorberschicht 4, beispielsweise aus Cu (In, Ga) $(S,Se)_2$, die unmittelbar auf der Rückelektrode 3 aufgebracht ist. Die Absorberschicht 4 wurde beispielsweise mit dem eingangs beschriebenen RTP-Prozess abgeschieden und hat beispielsweise eine Dicke von 1,5 $\mu$m.

Auf der Absorberschicht 4 ist die erste Pufferschicht 5 angeordnet. Die erste Pufferschicht 5 enthält ein Halbleitermaterial der Formel $K_xIn_yS_z$ oder $Cs_xIn_yS_z$ mit $0,05 \leq x/(x+y+z) \leq 0,25$ und $0,30 \leq y/(y+z) \leq 0,45$, vorzugsweise $0,05 \leq x/(x+y+z) \leq 0,20$ und $0,35 \leq y/(y+z) \leq 0,45$. Für $K_xIn_yS_z$ gilt bevorzugt: $0,05 \leq x/(x+y+z) \leq 0,15$ und $0,35 \leq y/(y+z) \leq 0,45$. Für $Cs_xIn_yS_z$ gilt bevorzugt: $0,05 \leq x/(x+y+z) \leq 0,12$ und $0,35 \leq y/(y+z) \leq 0,45$.

Wie eingangs bereits dargestellt wurde, weist die erste Pufferschicht 5, neben einem Halogen, falls Kalium bzw. Cäsium in einer Halogenverbindung abgeschieden wurden, vorteilhaft keinen wesentlichen Anteil ($\leq$ 1 Atom-%) an weiteren Elementen auf. Die Schichtdicke der Pufferschicht 5 liegt vorzugsweise im Bereich von 15 nm bis 60 nm und beträgt beispielsweise 30 nm.

Oberhalb der ersten Pufferschicht 5 ist die zweite Pufferschicht 6 angeordnet. Die zweite Pufferschicht 6 ist optional, d.h. sie muss nicht zwingend im Schichtsystem 1 vorhanden sein. Die Pufferschicht 6 enthält beispielsweise undotiertes Zinkoxid (i-ZnO).

Oberhalb der zweiten Pufferschicht 6 ist die Frontelektrode 7 angeordnet, die als Vorderseitenkontakt dient und für Strahlung im sichtbaren Spektralbereich transparent ist ("Fensterschicht"). In der Regel wird für die Frontelektrode 7 ein dotiertes Metalloxid (TCO = Transparent Conductive Oxide) eingesetzt, beispielsweise n-leitendes, Aluminium (Al)-dotiertes Zinkoxid (ZnO), Bor (B)-dotiertes Zinkoxid (ZnO), oder Gallium (Ga)-dotiertes Zinkoxid (ZnO). Die Schichtdicke der Frontelektrode 7 beträgt beispielsweise etwa 300 bis 2000 nm. Zum Schutz vor Umwelteinflüssen kann auf der Frontelektrode 7 eine beispielsweise aus Polyvinylbutyral (PVB), Ethylenvinylacetat (EVA) oder DNP bestehende Kunststoffschicht (Verkapselungsfolie) aufgebracht sein.

Zudem kann eine für Sonnenlicht transparente Deckplatte vorgesehen sein, die beispielsweise aus extraweißem Glas (Frontglas) mit geringem Eisengehalt besteht und eine Dicke von beispielsweise 1 bis 4 mm aufweist.

Der grundsätzliche Aufbau einer Dünnschichtsolarzelle oder eines Dünnschichtsolarmoduls ist dem Fachmann beispielsweise aus im Handel verfügbaren Dünnschichtsolarzellen oder Dünnschichtsolarmodulen wohlbekannt und wurde zudem in zahlreichen Druckschriften der Patentliteratur bereits eingehend beschrieben, beispielsweise in DE 19956735 B4.

In der in Figur 1 gezeigten Substratkonfiguration grenzt die Rückelektrode 3 an das Substrat 2 an. Es versteht sich, dass das Schichtsystem 1 gleichermaßen über eine Superstratkonfiguration verfügen kann, bei welcher das Substrat 2 transparent und die Frontelektrode 7 auf einer der Lichteintrittsseite abgewandten Oberfläche des Substrats 2 angeordnet ist.

Das Schichtsystem 1 kann zur Herstellung integriert serienverschalteter Dünnschichtsolarzellen 100 dienen, wobei das Schichtsystem 1, die Rückelektrode 3 und die Frontelektrode 7 in an sich bekannter Weise durch verschiedene Strukturierungslinien ("P1" für Rückelektrode, "P2" für Kontakt Frontelektrode/Rückelektrode und "P3" für Trennung der Frontelektrode) strukturiert wird.

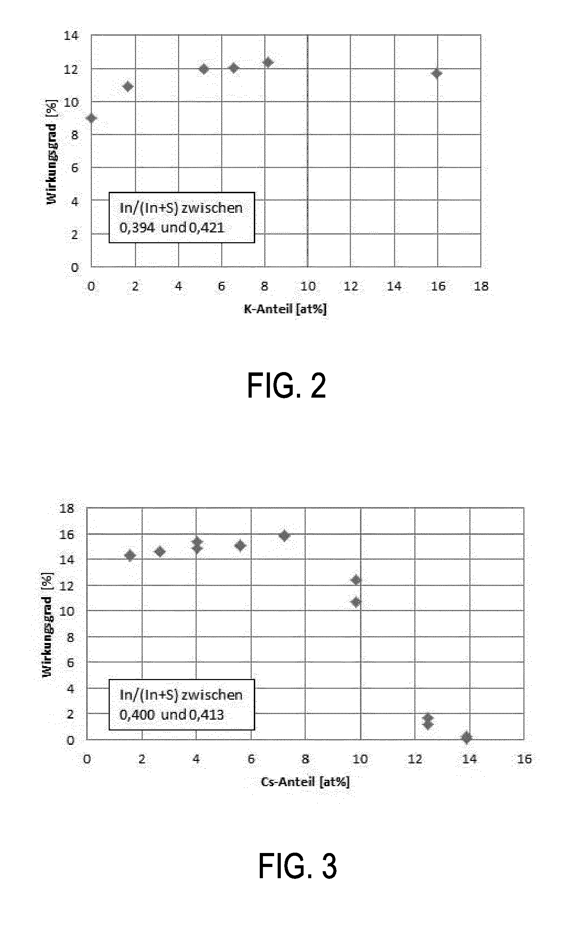

Figur 2 zeigt ein Diagramm des Wirkungsgrads von Dünnschichtsolarzellen 100 gemäß dem Aufbau von Figur 1 in Abhängigkeit des Kalium-Anteils in der ersten Pufferschicht 5, die ein Halbleitermaterial der Formel $K_xIn_yS_z$ aufweist. Die Dünnschichtsolarzelle 100 enthält ein Substrat 2 aus Glas sowie eine Rückelektrode 3 aus einer $Si_3N_4$-Barriere-Schicht und einer Molybdän-Schicht. Auf der Rückelektrode 3 ist eine Absorberschicht 4 aus $Cu(In,Ga)(S,Se)_2$ angeordnet, die nach dem oben beschriebenen RTP-Prozess abgeschieden wurde. Auf der Absorberschicht 4 ist die erste Pufferschicht 5 angeordnet. Die Schichtdicke der ersten Pufferschicht 5 beträgt 30 nm. Auf der ersten Pufferschicht 5 ist eine 100 nm dicke zweite Pufferschicht 6 angeordnet, die undotiertes Zinkoxid enthält. Auf der zweiten Pufferschicht 6 ist eine 1200 nm dicke Frontelektrode 7 angeordnet, die n-leitendes Zinkoxid enthält. Die Fläche der Dünnschichtsolarzelle 100 beträgt beispielsweise 1,4 cm$^2$.

Wie in Fig. 2 angegeben, liegen in der ersten Pufferschicht 5 Indium und Schwefel in folgendem Stoffmengenverhältnis vor: $0,394 \leq y/(y+z) \leq 0,421$. Der Kaliumanteil der ersten Pufferschicht 5 variiert von 0 Atom-% bis 16 Atom-%. Die Messungen ergaben einen maximalen Wirkungsgrad von ca. 12,5%, wobei erkennbar ist, dass der Wirkungsgrad deutlich oberhalb des Wirkungsgrads (ca. 9%) einer vergleichbaren Solarzelle ohne Kalium in der ersten Pufferschicht 5 liegt.

Figur 3 zeigt ein Diagramm des Wirkungsgrads von Dünnschichtsolarzellen 100 gemäß dem Aufbau von Figur 1 in Abhängigkeit des Cäsium-Anteils in der ersten Pufferschicht 5, die ein Halbleitermaterial der Formel $Cs_xIn_yS_z$ aufweist. Die Solarzellen des Aufbaus von Figur 3 entsprechen jenen von Figur 2, mit Ausnahme, dass das Indiumsulfid-haltige Halbleitermaterial der ersten Pufferschicht 5 mit Cäsium versehen wurde.

Wie in Figur 3 angegeben, liegen in der ersten Pufferschicht 5 Indium und Schwefel in folgendem Stoffmengenverhältnis vor: $0,400 \leq y/(y+z) \leq 0,413$. Der Cäsiumanteil der ersten Pufferschicht 5 variiert von ca. 1,5 Atom-% bis ca. 14 Atom-%. Die Messungen ergaben einen maximalen Wirkungsgrad von ca. 16%, wobei der Wirkungsgrad bis zu einem Cäsiumanteil von ca. 8 Atom-% deutlich oberhalb von 14% liegt und ab einem Cäsiumanteil von ca. 10 Atom-% abfällt.

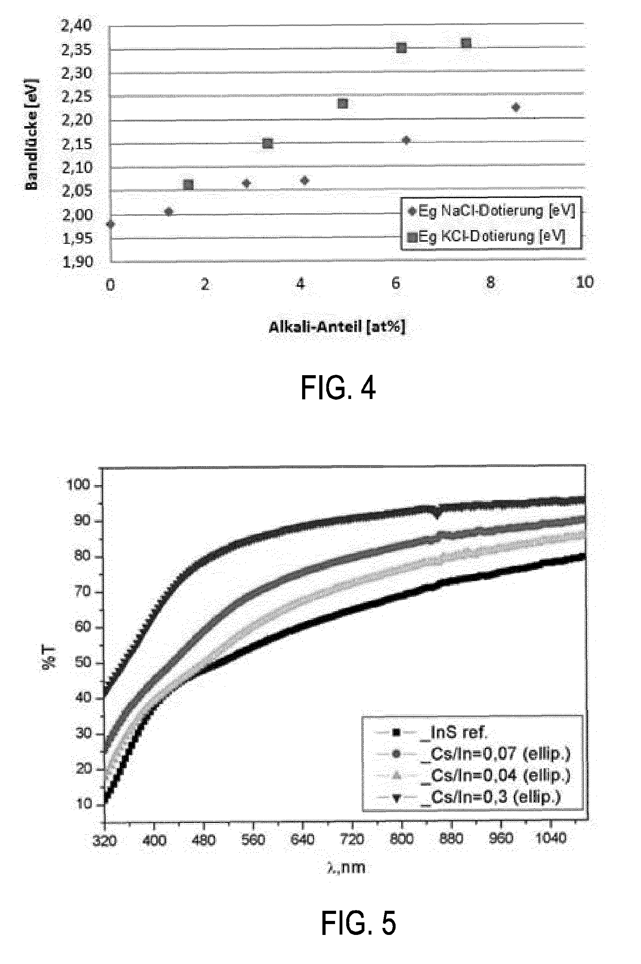

Figur 4 zeigt eine Messung der optischen Bandlücke Eg in Elektronenvolt (eV) in Abhängigkeit des Kaliumgehalts von durch Koverdampfen von KCl und InS hergestellten $K_xIn_ySz(:Cl)$-Pufferschichten. Als Vergleichsmessung ist die optische Bandlücke Eg in Abhängigkeit des Natriumgehalts von durch Koverdampfen von NaCl und InS hergestellten $Na_xIn_ySz(:Cl)$-Pufferschichten gezeigt. Das Mengenverhältnis $y/(y+z)$ betrug ca. 0,39 bis 0,42. Die Bandlücke wurde mittels Ellipsometrie, der Kaliumgehalt mittels Röntgenfluoreszenzanalyse (RFA) über den Chlorgehalt bestimmt.

Wie aus Figur 4 hervorgeht, steigt die Bandlücke bei einem Kaliumgehalt im Bereich von 0 bis 10,5 Atom-% näherungsweise linear von ca. 2 eV bis auf fast 2,5 eV an, was in einer Dünnschichtsolarzelle durch die reduzierte Absorption zu einem entsprechenden Anstieg des Kurschlussstroms führt. Die Bandlücken der Na-haltigen Indiumsulfid-Pufferschichten liegen deutlich unterhalb von jenen der K-haltigen Indiumsulfid-Pufferschichten.

Figur 5 zeigt eine Messung der optischen Transmission von $Cs_xIn_yS_z$ -Pufferschichten auf Glas in Abhängigkeit des Cäsiumanteils. Der jeweilige Cäsiumgehalt in der Pufferschicht ist im Diagramm angegeben, wobei sich die unterste Kurve als Referenzmessung auf eine cäsiumfreie Indiumsulfuid-Pufferschicht bezieht.

In Figur 5 ist deutlich zu erkennen, dass sich mit zunehmendem Cäsiumanteil der Beginn der Transmission hin zu kleineren Wellenlängen verschiebt, was durch eine Aufweitung der Bandlücke verursacht wird. Insgesamt kann mit zunehmendem Cäsiumgehalt eine Verbesserung der Transmission beobachtet werden.

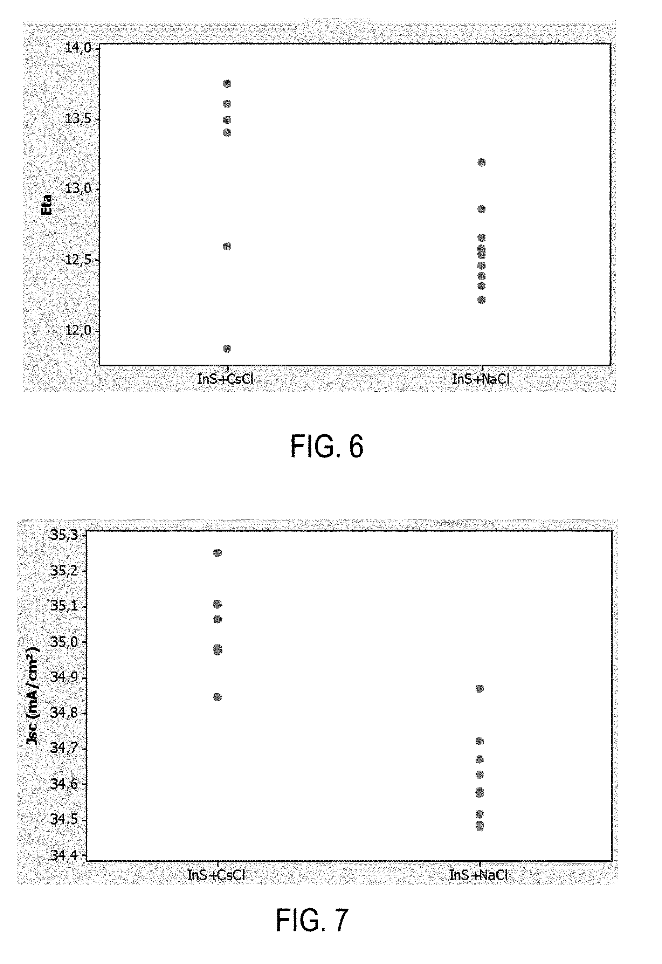

Fig. 6 zeigt einen Vergleich der Wirkungsgrade von Dünnschichtsolarmodulen mit $In_yS_z$:CsCl-Pufferschicht (links) und $In_yS_z$:NaCl-Pufferschicht (rechts). Ersichtlich können mit einer Pufferschicht mit einem Cäsium-haltigen Indiumsulfid-Halbleitermaterial deutlich höhere Wirkungsgrade erzielt werden als mit einer Pufferschicht mit einem Natrium-haltigen Indiumsulfid-Halbleitermaterial.

In Fig. 7 ist der dazugehörige Kurzschlussstrom Isc (mA/cm$^2$) gezeigt. Man erkennt eine deutliche Erhöhung des Kurzschlussstroms für Solarmodule mit einer Pufferschicht mit einem Cäsium-haltigen Indiumsulfid-Halbleitermaterial gegenüber einer Pufferschicht mit einem Natrium-haltigen Indiumsulfid-Halbleitermaterial. Das Einbringen von CsCl in die Pufferschicht verbessert also die Transmission.

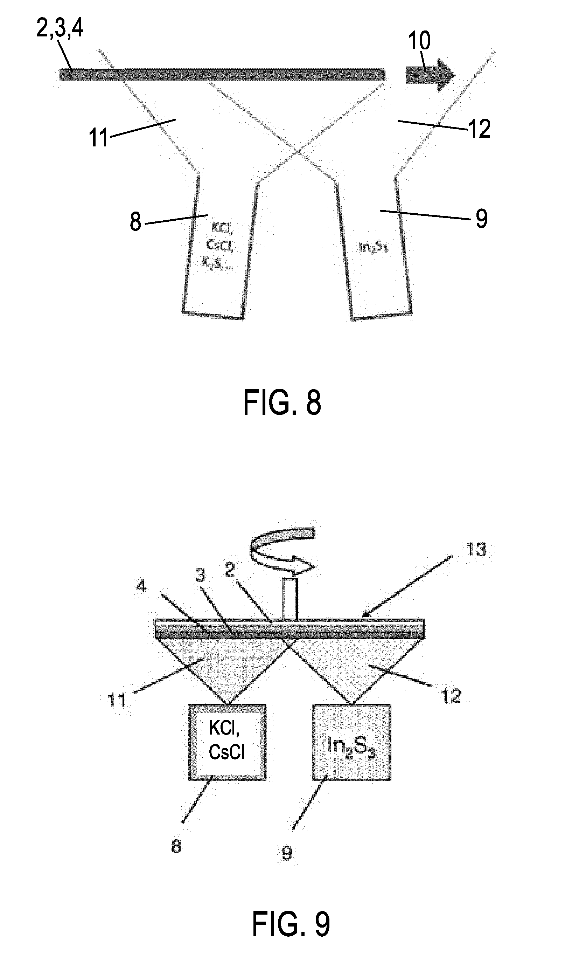

Figur 8 zeigt eine schematische Darstellung eines In-Line-Verfahrens zur Herstellung einer Pufferschicht 5 aus $A_xIn_yS_z$ mit A = Kalium oder Cäsium. Hierbei wird das Substrat 2 mit Rückelektrode 3 und Absorberschicht 4 an den Dampfkeulen 11, 12 einer Kalium- oder Cäsium-Quelle 8 und einer Indiumsulfid-Quelle 9 vorbeigeführt. Die Transportrichtung ist durch einen Pfeil mit dem Bezugszeichen 10 angegeben. Wie schematisch veranschaulicht, überlappen sich die Dampfkeulen 11, 12 der beiden Quellen 8, 9 teilweise.

Als Ausgangsmaterialien zur Herstellung eines Halbleitermaterials der Formel $K_xIn_yS_z$ oder $Cs_xIn_yS_z$ können Kalium- bzw. Cäsiumverbindungen und Indiumsulfid eingesetzt werden. Beispielsweise können Verbindungen von Kalium bzw. Cäsium mit dem Chalkogen Schwefel, insbesondere $K_2S$ bzw. $Cs_2S$, verwendet werden. Alternativ können Halogensalze von Kalium bzw. Cäsium verwendet werden, beispielsweise Kaliumfluorid (KF) bzw. Cäsiumfluorid (CsF), Kaliumchlorid (KCl) bzw. Cäsiumchlorid (CsCl), oder entsprechende Bromide oder Iodide. Dies bietet insbesondere durch die erleichterte Handhabung dieser relativ ungefährlichen Materialien in einem Produktionsumfeld Vorteile.

Auf diese Weise wird die Absorberschicht 4 mit dünnen Schichten eines Halogens oder Sulfids von Kalium bzw. Cäsium und Indiumsulfid beschichtet, die sich vermischen. Die beiden Quellen 8, 9 sind beispielsweise Effusionszellen, aus denen die jeweilige Substanz thermisch verdampft wird. Alternativ ist jede andere Form der Erzeugung von Dampfkeulen 11, 12 zur Abscheidung der Pufferschicht 5 geeignet, sofern sich das beanspruchte Verhältnis der Stoffmengenanteile von Kalium bzw. Cäsium sowie Indium und Schwefel einstellen lässt. Alternative Quellen sind beispielsweise Schiffchen von Linearverdampfern oder Tiegel von Elektronenstrahlverdampfern.

Da die Kalium- bzw. Cäsiumverbindung zeitlich vor dem Indiumsulfid auf der Absorberschicht 4 abgeschieden wird, kann eine elektrische Passivierung der Grenzfläche erreicht werden, wodurch sich der Wirkungsgrad der Solarzelle verbessert.

Alternativ können zur Durchführung des erfindungsgemäßen Verfahrens ein oder mehrere Quellen von Kalium bzw. Cäsium 8 und ein oder mehrere Quellen von Indiumsulfid 9 ein- oder zweidimensional alternierend angeordnet sein, so dass

- zwei oder mehr Kalium- bzw. Cäsiumschichten alternierend mit einer oder mehreren Indiumsulfidschichten, oder
- zwei oder mehr Indiumsulfidschichten alternierend mit einer oder mehreren Kalium- bzw. Cäsiumschichten, auf der Absorberschicht 4 abgeschieden werden. Hierdurch kann eine sehr homogene Pufferschicht 5 hergestellt werden, wodurch sich der Wirkungsgrad der Solarzelle erhöht. Besonders vorteilhaft ist es, wenn als erste Schicht eine Kalium- bzw. Cäsiumschicht auf die Absorberschicht 4 aufgebracht wird, um zur weiteren Verbesserung des Wirkungsgrads eine elektrische Passivierung der Grenzfläche zu erreichen.

Figur 9 zeigt eine weitere alternative Ausführungsform des erfindungsgemäßen Verfahrens am Beispiel eines Rotations-Verfahrens. Das Substrat 2 mit Rückelektrode 3 und Absorberschicht 4 ist auf einem drehbaren Probenträger 13 angeordnet, beispielsweise auf einem Probenkarussell. Unterhalb des Probenträgers 13 befinden sich alternierend angeordnete Quellen von Kalium bzw. Cäsium 8 und Indiumsulfid 9. Während der Abscheidung der Pufferschicht 5 wird der Probenträger 13 gedreht. Dadurch wird das Substrat 2 in den Dampfkeulen 11, 12 bewegt und beschichtet.

Sowohl im Laborprozess mit rotierendem Substrat 2 auf einem drehbaren Probenträger 13 als auch im industriellen In-Line-Verfahren mit linearem Vorschub des Substrats 2 können die Verdampfungsraten der Quellen 8,9 so gewählt werden, dass der Anteil an Kalium- und/oder Cäsium variiert, so dass ein Kalium- und/oder Cäsium-Gradient in der Pufferschicht 5 erzeugt werden kann.

Aus den vorstehenden Ausführungen ist klar geworden, dass durch die vorliegende Erfindung die Nachteile von bisher verwendeten CdS-Pufferschichten bei Dünnschichtsolarzellen überwunden werden können, wobei der Wirkungsgrad und die Stabilität der damit erzeugten Dünnschichtsolarzellen ebenfalls sehr gut oder besser ist. Erreicht wird dies durch eine mit Kalium bzw. Cäsium versehene Indiumsulfid-Pufferschicht. Durch das Einbringen von Kalium oder Cäsium bilden sich unterschiedliche Kristallstrukturen aus, was beim Schichtwachstum zu einer feinkristallinen Schicht führt. Zudem stört der relativ große Atomradius die Ausbildung der Indiumsulfid-Kristallstruktur und verringert auch dadurch die Kristallinität. Im Vergleich zu Natrium haben Kalium und Cäsium einen größeren Ionenradius und zeigen somit eine reduzierte Diffusionsneigung. Durch Kalium und Cäsium kann die optische Bandlücke der Indiumsulfid-Pufferschicht aufgeweitet werden. Im Vergleich zu Natrium-haltigen Indiumsulfid-Pufferschichten kann eine bessere Bandanpassung, eine verminderte Lichtabsorption, sowie eine deutliche Erhöhung des Kurschlussstroms und verbesserte Transmission, sowie insgesamt ein höherer Wirkungsgrad erreicht werden. Gleichzeitig ist das Herstellungsverfahren kostengünstig, effektiv und umweltschonend.

Es hat sich gezeigt, dass mit dem erfindungsgemäßen Schichtsystem vergleichbar gute Solarzellencharakteristika erreicht werden können, wie sie bei herkömmlichen CdS-Pufferschichten vorliegen. Mit dem erfindungsgemäßen Aufbau konnten sehr hohe Wirkungsgrade bis zu 16% erreicht werden. Dies war für den Fachmann unerwartet und überraschend.

Bezugszeichen

1    Schichtsystem

2    Substrat

3    Rückelektrode

4    Absorberschicht

5    erste Pufferschicht

6    zweite Pufferschicht

7    Frontelektrode

8    Kalium-/Cäsium-Quelle

9    Indiumsulfid-Quelle

10   Transportrichtung

11   Kalium-/Cäsium-Dampfkeule

12   Indiumsulfid-Dampfkeule

13   Probenträger

100  Dünnschichtsolarzelle

**Patentansprüche**

1.  Schichtsystem (1) für Dünnschichtsolarzellen (100), umfassend:

    - eine Absorberschicht (4), die einen ChalkogenidVerbindungshalbleiter enthält,
    - eine Pufferschicht (5), die auf der Absorberschicht (4) angeordnet ist, wobei die Pufferschicht (5) ein Halbleitermaterial, enthaltend Indium (In), Schwefel (S) und wenigstens einem Element, gewählt aus der Gruppe, bestehend aus Kalium (K) und Cäsium (Cs), aufweist.

2.  Schichtsystem (1) nach Anspruch 1, wobei die Pufferschicht (5) ein Halbleitermaterial der Formel $A_x In_y S_z$ aufweist, wobei A wenigstens ein Element, gewählt aus der Gruppe, bestehend aus Kalium (K) und Cäsium (Cs), ist, mit

$$0,05 \leq x/(x+y+z) \leq 0,25$$

und

$$0,30 \leq y/(y+z) \leq 0,45.$$

3.  Schichtsystem (1) nach Anspruch 2, wobei in der Pufferschicht (5)

$$0,05 \leq x/(x+y+z) \leq 0,20$$

und

$$0,35 \leq y/(y+z) \leq 0,45$$

beträgt.

4.  Schichtsystem (1) nach Anspruch 2, wobei in der Pufferschicht (5) mit A = K

$$0,05 \leq x/(x+y+z) \leq 0,15$$

und

$$0,35 \leq y/(y+z) \leq 0,45$$

beträgt.

5.  Schichtsystem (1) nach Anspruch 2, wobei in der Pufferschicht (5) mit A = Cs

$$0,05 \leq x/(x+y+z) \leq 0,12$$

und

$$0,35 \leq y/(y+z) \leq 0,45$$

beträgt.

6.  Schichtsystem (1) nach einem der vorhergehenden Ansprüche 1 bis 5, wobei die Pufferschicht (5) wenigstens ein Halogen, insbesondere gewählt aus der Gruppe, bestehend aus Fluor (F), Chlor (Cl), Brom (Br) und Iod (I), aufweist.

7. Schichtsystem (1) nach Anspruch 6, wobei ein Halogengehalt der Pufferschicht (5) einem Alkaligehalt der Pufferschicht (5) entspricht.

8. Schichtsystem (1) nach einem der vorhergehenden Ansprüche 1 bis 7, wobei auf einer $A_xIn_yS_z$ enthaltenden ersten Pufferschicht (5) eine zweite Pufferschicht (6) angeordnet ist, wobei die zweite Pufferschicht (6) insbesondere undotiertes Zinkoxid (ZnO) und/oder undotiertes Zink-Magnesiumoxid (ZnMgO) enthält.

9. Schichtsystem (1) nach einem der vorhergehenden Ansprüche 1 bis 8, wobei die Pufferschicht (5) Zink (Zn) enthält, wobei der Zinkgehalt maximal 15 Atom-% beträgt.

10. Schichtsystem (1) nach einem der vorhergehenden Ansprüche 8 und 9, wobei der Zinkgehalt der ersten Pufferschicht (5) zur zweiten Pufferschicht (6) hin ansteigt.

11. Schichtsystem (1) nach einem der vorhergehenden Ansprüche 1 bis 10, wobei die Pufferschicht (5) eine Schichtdicke im Bereich von 5 nm bis 150 nm, insbesondere im Bereich von 15 nm bis 60 nm, aufweist.

12. Schichtsystem (1) nach einem der vorhergehenden Ansprüche 1 bis 11, wobei die Pufferschicht (5) so ausgebildet ist, dass eine Bandlücke der Pufferschicht (5) im Bereich von 2 Elektronenvolt (eV) bis 2,8 Elektronenvolt (eV) liegt.

13. Dünnschichtsolarzelle (100), umfassend:

    - ein Substrat (2),
    - eine Rückelektrode (3), die auf dem Substrat (2) angeordnet ist,
    - ein Schichtsystem (1) nach einem der Ansprüche 1 bis 12, das auf der Rückelektrode (3) angeordnet ist, und
    - eine Frontelektrode (7), die auf dem Schichtsystem (1) angeordnet ist.

14. Verfahren zur Herstellung eines Schichtsystems (1) nach einem der vorhergehenden Ansprüche 1 bis 12, bei welchem

    a) eine Absorberschicht (4), die einen ChalkogenidVerbindungshalbleiter enthält, bereitgestellt wird und
    b) eine Pufferschicht (5) auf der Absorberschicht (4) angeordnet wird, wobei die Pufferschicht ein Halbleitermaterial der Formel $A_xIn_yS_z$ aufweist, wobei A wenigstens ein Element, gewählt aus der Gruppe, bestehend aus K und Cs, ist, wobei eine Kalium- und/oder Cäsium-Verbindung und Indiumsulfid auf die Absorberschicht (4) aufgebracht werden, insbesondere durch Atomic Layer Deposition (ALD), Ion Layer Gas Deposition (ILGAR), Sprühpyrolyse, Chemical Vapour Deposition (CVD) oder Physical Vapor Deposition (PVD), Sputtern, thermisches Verdampfen oder Elektronenstrahlverdampfen, insbesondere aus separaten Quellen für die Kalium- und/oder Cäsium-Verbindung und Indiumsulfid.

15. Verfahren nach Anspruch 14, wobei die Absorberschicht (4) in einem In-Line-Verfahren oder Rotations-Verfahren an mindestens einer Dampfkeule (11) einer Kalium- und/oder Cäsium-Verbindung und mindestens einer Dampfkeule (12) von Indiumsulfid vorbeigeführt wird, insbesondere mit wenigstens teilweise überlappenden Dampfkeulen (11, 12).

FIG. 1

FIG. 2

FIG. 3

FIG. 4

FIG. 5

FIG. 6

FIG. 7

FIG. 8

FIG. 9

**Europäisches Patentamt**
**European Patent Office**
**Office européen des brevets**

**EUROPÄISCHER RECHERCHENBERICHT**

Nummer der Anmeldung

EP 13 19 9305

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| A | RODRIGO SÁEZ-ARAOZ ET AL: "ILGAR In2S3 buffer layers for Cd-free Cu(In,Ga)(S,Se)2 solar cells with certified efficiencies above 16%", PROGRESS IN PHOTOVOLTAICS: RESEARCH AND APPLICATIONS, 1. Juli 2012 (2012-07-01), Seiten n/a-n/a, XP055041070, ISSN: 1062-7995, DOI: 10.1002/pip.2268 * das ganze Dokument * ----- | 1-5,13, 14 | INV. H01L31/0749 |
| A | EP 2 200 097 A1 (SAINT GOBAIN [FR]) 23. Juni 2010 (2010-06-23) * Zusammenfassung; Abbildung 4 * * Absatz [0003] * ----- | 1-5,13, 14 | |
| A | US 2012/103411 A1 (GONZALEZ PEDRO [US]) 3. Mai 2012 (2012-05-03) * Zusammenfassung * * Absatz [0037] * ----- | 1-5,13, 14 | |
| | | | **RECHERCHIERTE SACHGEBIETE (IPC)** |
| | | | H01L |

Der vorliegende Recherchenbericht wurde für alle Patentansprüche erstellt

| Recherchenort | Abschlußdatum der Recherche | Prüfer |
|---|---|---|
| Berlin | 15. Mai 2014 | Favre, Pierre |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**     EP 13 19 9305

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

15-05-2014

| Im Recherchenbericht angeführtes Patentdokument | Datum der Veröffentlichung | Mitglied(er) der Patentfamilie | Datum der Veröffentlichung |
|---|---|---|---|
| EP 2200097 A1 | 23-06-2010 | CN 101789394 A<br>EP 2200097 A1<br>US 2010147384 A1 | 28-07-2010<br>23-06-2010<br>17-06-2010 |
| US 2012103411 A1 | 03-05-2012 | US 2012103411 A1<br>WO 2012058454 A1 | 03-05-2012<br>03-05-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- WO 2009141132 A2
- EP 1356528 A1
- DE 19956735 B4